# EUROPEAN PATENT SPECIFICATION

(11) **EP 4 468 372 B1**
(45) Date of publication and mention of the grant of the patent: **15.07.2026**
(21) Application number: 23188341.4
(22) Date of filing: 28.07.2023
(51) Int. Cl.: H10F 77/20, H10F 19/80, H10F 19/90

(54) **PHOTOVOLTAIC MODULE, MANUFACTURING METHOD FOR PHOTOVOLTAIC MODULE, AND MACHINING DEVICE**
FOTOVOLTAISCHES MODUL, HERSTELLUNGSVERFAHREN FÜR FOTOVOLTAISCHES MODUL UND BEARBEITUNGSVORRICHTUNG
MODULE PHOTOVOLTAÏQUE, PROCÉDÉ DE FABRICATION DE MODULE PHOTOVOLTAÏQUE ET DISPOSITIF D'USINAGE

(30) Priority: 26.05.2023 CN 202310610355; 26.05.2023 CN 202310609235
(43) Date of publication of application: 27.11.2024
(73) Proprietor: JINKO SOLAR CO., LTD, ShangRao, Jiangxi 334100 (CN); ZHEJIANG JINKO SOLAR CO., LTD., Haining, Zhejiang 314416 (CN)
(72) Inventor: TAO, Wusong, SHANGRAO 334100 (CN); WANG, Luchuang, SHANGRAO 334100 (CN); QIN, Niannian, SHANGRAO 334100 (CN)
(74) Representative: Müller Schupfner & Partner Patent- und Rechtsanwaltspartnerschaft mbB (Muc)

(56) References cited:
- CN-A- 104 272 475
- US-A1- 2011 290 298
- US-A1- 2013 298 988
- US-A1- 2016 181 454
- US-A1- 2018 233 615

## Description

### TECHNICAL FIELD

The present disclosure relates to the technical field of photovoltaic power generation, and in particular, to a photovoltaic module, a manufacturing method for a photovoltaic module, and a machining device.

### BACKGROUND

In the design of a rear-contact solar cell, positive and negative electrodes of the solar cell are both designed on a rear surface of the solar cell, and at the same time, gate lines and connection points on a far side of the solar cell almost fit edges of a silicon wafer of the solar cell. During soldering of solar cells into a solar cell string, there is a greater risk of problems such as cold soldering at the connection points, which reduces a yield of manufacturing of the solar cell.

US2013/0298988A1 discloses a conventional rear-contact solar cell string.

### SUMMARY

The present disclosure provides a photovoltaic module according to claim 1, a manufacturing method for a photovoltaic module according to claim 7, and a machining device according to claim 9 to solve the problem that cold soldering easily occurs at connection points of solar cells.

In the invention, the second region has a width less than or equal to 30 µm.

In an embodiment, the second region has a surface pore density less than that of the first region.

In the invention, at least one recessed portion is arranged on a surface of the first region.

In an embodiment, in the first region, an arrangement density of the at least one recessed portion an arrangement density ranges from 100 pcs/mm² to 2000 pcs/mm².

In an embodiment, along a thickness direction of the photovoltaic module, a projection of the at least one recessed portion is located outside projections of the electrode line.

In the invention, the at least one recessed portion comprises a plurality of recessed portions arranged on the surface of the first region, the recessed portions are arranged apart from each other on a surface of the first region.

In an embodiment not part of the invention, the at least one recessed portion comprises a plurality of recessed portions arranged on the surface of the first region, and adjacent recessed portions of the plurality of recessed portions (133) are interconnected with each other.

In an embodiment, along a thickness direction of the photovoltaic module, a projection of each of the at least one recessed portion in a corresponding solar cell is in a shape of a circle or an ellipse.

In an embodiment, along a thickness direction of the photovoltaic module, a projection of each of the at least one recessed portion in the solar cell has a size ranging from 3 µm to 15 µm along a width direction of the photovoltaic module.

In an embodiment, the first region is provided with a solder paste.

Some embodiments of the present disclosure further provide a method for manufacturing a photovoltaic module, the photovoltaic module including a solar cell string, a back sheet, an adhesive film, and photovoltaic glass, and the solar cell string including solar cells, electrode lines, and connecting members, wherein the method includes: placing the connecting members in soldering regions of the solar cells; placing the solar cells with the connecting members on an operating platform; placing each of the the electrode lines on a side of a corresponding solar cell provided with the connecting members on thereon side; heating the electrode lines and the connecting members to obtain the solar cell string; and laminating the back sheet, the adhesive film, the solar cell strings, and the photovoltaic glass to obtain the photovoltaic module.

In an embodiment, each of the solar cells includes a positive busbar and a negative busbar, the positive busbars and the negative busbars are alternately arranged along a width direction of the photovoltaic module, and when the solar cells with the connecting members are placed on the operating platform, and the method for manufacturing a photovoltaic module includes: rotating one of two adjacent solar cells by 180° such that, in the adjacent solar cells, the positive busbar of one of the two adjacent solar cells and the negative busbar of the other of the two adjacent solar cells are located on a same straight line along a length direction of the photovoltaic module.

In an embodiment, the heating the electrode lines and the connecting members to obtain the solar cell string is performed at a heating temperature ranging from 130°C to 220°C for 1.5s to 6s.

In an embodiment, the heating the electrode lines and the connecting members to obtain the solar cell string is performed at a heating temperature ranging from 230°C to 240°C, for no more than 5 s.

Some embodiments of the present disclosure further provide a machining device, for manufacturing a photovoltaic module, the photovoltaic module including solar cells, electrode lines, and connecting members, and the machining device includes: an operating platform, the solar cells being located on a surface of the operating platform; a pressing tool, the pressing tool being located on one side of the operating platform where the solar cells are placed; and a heating apparatus, the heating apparatus being configured to heat the solar cells and the connecting members.

In an embodiment, the heating apparatus is located in the operating platform, and the solar cells are placed in the heating apparatus.

In an embodiment, the heating apparatus is a curing furnace, and the operating platform is capable of entering the curing furnace;

the curing furnace including a heating member, and the heating member being located on a side of a corresponding solar cell away from the operating platform.

In an embodiment, the pressing tool includes a bracket and abutting members, and the bracket is arranged parallel to each of the electrode lines along a height direction of the machining device electrode line, and each of the abutting members has one end connected to the bracket and another end capable of abutting against one of the electrode lines.

In an embodiment, the pressing tool further includes elastic members, and the bracket and the abutting members are connected to each other through the elastic members.

It should be understood that the general description above and the detailed description in the following are merely exemplary and illustrative, and cannot limit the present disclosure.

### BRIEF DESCRIPTION OF DRAWINGS

FIG. 1 is a schematic structural diagram of solar cells according to some embodiments of the present disclosure;
FIG. 2 is a schematic structural diagram of solar cells and connecting members according to some embodiments of the present disclosure;
FIG. 3 is a schematic structural diagram of solar cell strings according to some embodiments of the present disclosure;
FIG. 4 is a schematic structural diagram of a machining device according to some embodiments of the present disclosure;
FIG. 5 is a microstructural diagram of a connecting member according to some embodiments of the present disclosure;
FIG. 6 is a partial enlarged view of the connecting member according to some embodiments of the present disclosure;
FIG. 7 is a schematic structural diagram of the connecting member according to some embodiments of the present disclosure;
FIG. 8 is a microstructural diagram of a connecting member according to some other embodiments of the present disclosure;
FIG. 9 is a partial enlarged view of the connecting member according to some other embodiments of the present disclosure;
FIG. 10 is a schematic structural diagram of a connecting member according to some other embodiments of the present disclosure; and
FIG. 11 is a schematic structural diagram of a connecting member according to some other embodiments of the present disclosure.

### Reference signs:

1: solar cell string;
   11: solar cell;
      111: soldering region;
   12: electrode line;
   13: connecting member;
      131: first region;
      132: second region;
      133: recessed portion;
      134: third region;
2: operating platform;
3: pressing tool;
   31: bracket;
   32: abutting member;
   33: elastic member.

The accompanying drawings herein are incorporated in and constitute a part of this specification, illustrate embodiments consistent with the present disclosure and, together with the specification, serve to explain the principles of the present disclosure.

### DESCRIPTION OF EMBODIMENTS

In order to better understand the technical solution of the present disclosure, embodiments of the present disclosure are described in detail below with reference to the accompanying drawings.

It is to be made clear that the described embodiments are only some rather than all of the embodiments of the present disclosure. All other embodiments obtained by those of ordinary skill in the art based on the embodiments in the present disclosure without creative efforts fall within the protection scope of the present disclosure.

The terms used in the embodiments of the present disclosure are intended only to describe particular embodiments and are not intended to limit the present disclosure. As used in the embodiments of the present disclosure and the appended claims, the singular forms of "a/an", "the", and "said" are intended to include plural forms, unless otherwise clearly specified by the context.

It is to be understood that the term "and/or" used herein is merely an association relationship describing associated objects, indicating that three relationships may exist. For example, A and/or B indicates that there are three cases of A alone, A and B together, and B alone. In addition, the character "/" herein generally means an "or" relationship between the associated objects.

It is to be noted that the location terms such as "above", "below", "left", and "right" described in the embodiments of the present disclosure are described with reference to the angles shown in the accompanying drawings, and should not be construed as limitations on the embodiments of the present disclosure. In addition, in the context, it is to be further understood that, when one element is referred to as being connected "above" or "below" another element, the one element may be directly connected "above" or "below" another element, or connected "above" or "below" another element via an intermediate element.

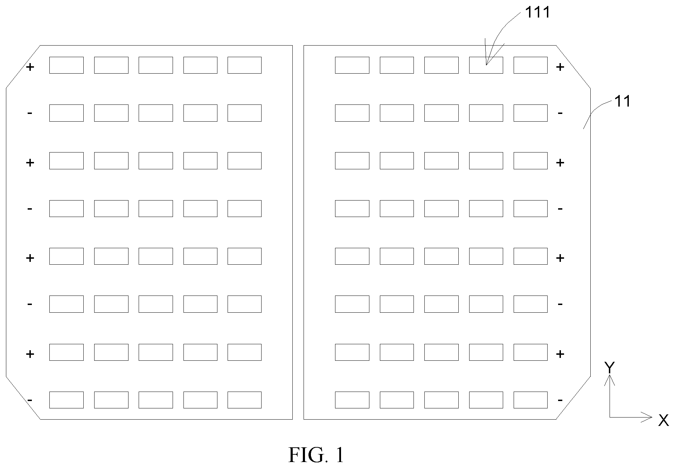

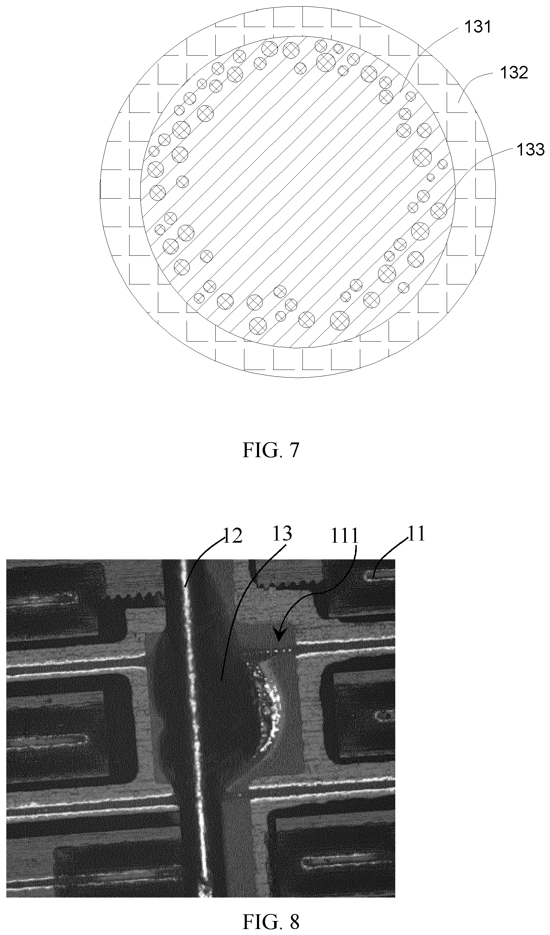

As shown in FIG. 1 to FIG. 7, some embodiments of the present disclosure provide a photovoltaic module, including solar cell strings 1 and electrode lines 12. The solar cell strings 1 each include solar cells 11 arranged in parallel. The electrode lines 12 are located on one sides of the solar cells 11 and configured to connect adjacent solar cells 11. soldering regions 111 are arranged on one sides of the solar cells 11 facing the electrode lines 12. The soldering regions 111 are arranged apart along a length direction X of the photovoltaic module. Connecting members 13 are arranged in the soldering regions 111, such that the electrode lines 12 are connected to the soldering regions 111 of the solar cells 11 through the connecting members 13. The connecting members 13 each include a first region 131 and a second region 132. The second region 132 is arranged around the first region 131, and transparency of the second region 132 is greater than that of the first region 131.

The solar cell 11 provided in some embodiments of the present disclosure is a rear-back solar cell 11. A positive busbar and a negative busbar in the solar cell 11 are both located on a same side of the solar cell 11. The soldering region 111 is arranged on the positive busbar and the negative busbar of the solar cell 11. The electrode line 12 is configured to connect the positive busbars and the negative busbars between adjacent solar cells 11. Therefore, along a thickness direction Z of the photovoltaic module, the electrode lines 12 can be located on a same side of the adjacent solar cells 11.

The positive busbar and the negative busbar of the rear-back solar cell 11 are both designed on a rear surface of the solar cell, and at the same time, a solder joint between a busbar and the electrode line 12 at an edge almost fit an edge of the solar cell 11. Therefore, there is a greater risk of problems such as cold soldering during the soldering. The arrangement of the connecting member 13 in the soldering region 111 can reduce a possibility of cold soldering between the electrode line 12 and the solar cell 11, helping to increase a yield of the photovoltaic module. Main components of the connecting member 13 are different metals such as tin-lead or tin-bismuth-silver, and organic solvents such as flux are also added to the connecting member 13 to facilitate soldering of the electrode line 12 and the solar cell 11. During the soldering, the connecting member 13 is heated and melted, and the organic solvents in the connecting member 13 may precipitate along a direction from the first region 131 to the second region 132. After the soldering, the precipitated organic solvents may gather at edges of the first region 131 in the connecting member 13 to form the second region 132. Due to greater transparency of the organic solvents, the transparency of the second region 132 is approximately 70% to 80% greater than the transparency of the first region 131.

In some possible embodiments, after the electrode line 12 is connected to the soldering region 111, the connecting member 13 has a recessed portion 133 on a surface.

Main components of the connecting member 13 are different metals such as tin-lead or tin-bismuth-silver, and organic solvents are also added to the connecting member 13 to facilitate soldering of the electrode line 12 and the solar cell 11. When the connecting member 13 is heated, the organic solvents may volatilize by heat, and a recessed portion 133 may be formed on the surface of the connecting member 13. After the organic solvents volatilize, it is beneficial to improve strength of the soldering between the electrode line 12 and the solar cell 11.

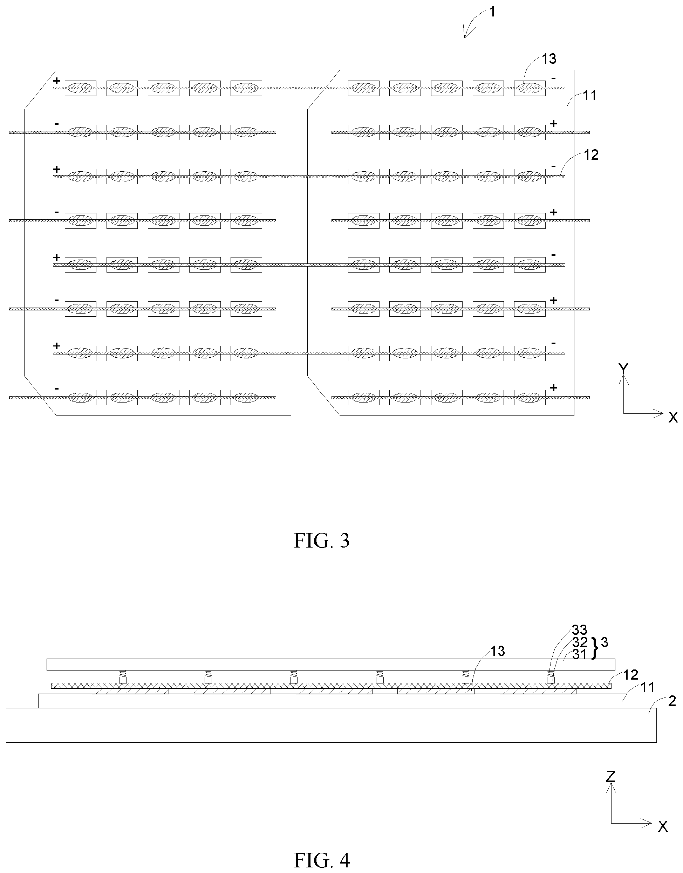

As shown in FIG. 3, FIG. 9, and FIG. 10, in some possible embodiments, along the thickness direction Z of the photovoltaic module, the electrode line 12 overlaps with the connecting member 13, and in projections along the thickness direction Z of the photovoltaic module, the projection of the recessed portion 133 on the solar cell 11 is located outside a projection region of the electrode line 12 on the solar cell 11.

In some possible embodiments, in the projections along the thickness direction Z of the photovoltaic module, the projection of the recessed portion 133 on the solar cell 11 overlaps with the projection of the electrode line 12 on the solar cell 11, such that the recessed portion 133 also exists at a position where the electrode line 12 overlaps with the connecting member 13.

When the connecting member 13 is heated, the organic solvents in the connecting member 13 volatilize when the connecting member 13 is not completely cured, such that the connecting member 13 has the recessed portion 133 on the surface after curing. Before the connecting member 13 is heated, the organic solvents are evenly mixed with other components in the connecting member 13. Therefore, the recessed portion 133 formed due to the volatilization of the organic solvents may overlap with the electrode line 12 or may not overlap with the electrode line 12. When the recessed portion 133 overlaps with the electrode line 12, an area of contact between the electrode line 12 and the connecting member 13 may be reduced, so strength of the connection between the electrode line 12 and the connecting member 13 may be reduced. Therefore, in an ideal state, the projection of the recessed portion 133 is located outside the projection of the electrode line 12.

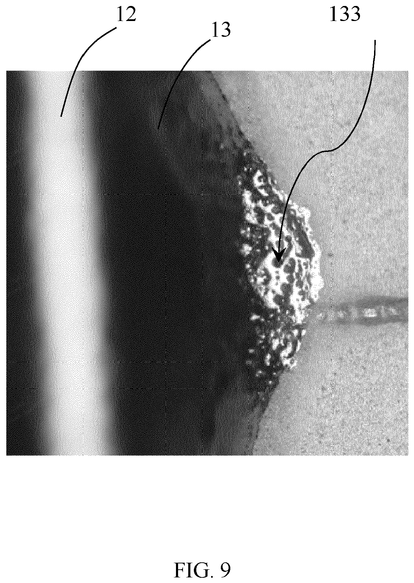

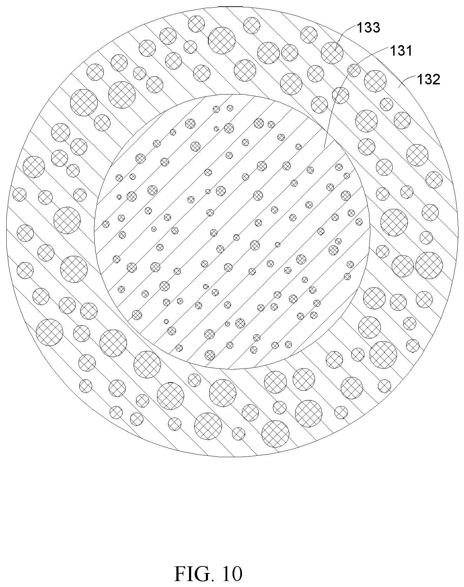

As shown in FIG. 9 and FIG. 10, in some possible embodiments, the connecting member 13 has recessed portions 133 on the surface, and the recessed portions 133 are arranged apart.

During the volatilization of the organic solvents, gaseous organic solvents may form bubbles on the surface of the connecting member 13. As the gaseous organic solvents in the bubbles gradually increase, the bubbles break to form recessed portions 133 on the surface of the connecting member 13. During the gasification of the organic solvents, adjacent organic solvents may gather into a bubble and then volatilize from the connecting member 13, such that the recessed portions 133 on the surface of the connecting member 13 are arranged apart.

In some possible embodiments, the connecting member 13 has recessed portions 133 on the surface, and adjacent recessed portions 133 are interconnected with each other.

In the case of more organic solvents in the connecting member 13 or a higher heating temperature, reaction is violent when the organic solvents volatilize, such that bubbles may be formed multiple times at a same position or similar positions on the surface of the connecting member 13. After breakage of the bubbles, recessed portions 133 interconnected with each other may be formed.

As shown in FIG. 10, in some possible embodiments, the connecting member 13 includes a first region 131 and a second region 132, wherein the second region 132 is arranged around the first region 131. Both the first region 131 and the second region 132 are provided with the recessed portions 133, and an average size of the recessed portions 133 in the first region 131 is smaller than an average size of the recessed portions 133 in the second region 132.

When the connecting member 13 is heated, the organic solvents in the connecting member 13 have one part that may volatilize in the first region 131 and the other part that may flow from the first region 131 to the second region 132 and then volatilize in the second region 132, such that the organic solvents volatilizing in the first region 131 are smaller than the organic solvents volatilizing in the second region 132. Therefore, sizes of the recessed portions 133 in the first region 131 are smaller than sizes of the recessed portions 133 in the second region 132, and it is also possible that a number of the recessed portions 133 in the first region 131 is less than that of the recessed portions 133 in the second region 132.

In some possible embodiments, arrangement density of the recessed portions 133 in the second region 132 ranges from 3×10³ pcs/mm² to 13×10⁴ pcs/mm².

The arrangement density of the recessed portions 133 in the second region 132 may be 3×10³ pcs/mm², 13×10³ pcs/mm², 23×10³ pcs/mm², 33×10³ pcs/mm², 43×10³ pcs/mm², 53×10³ pcs/mm², 63×10³ pcs/mm², 73×10³ pcs/mm², 83×10³ pcs/mm², 93×10³ pcs/mm², 3×10⁴ pcs/mm², 13×10⁴ pcs/mm² , or the like. If the number of the recessed portions 133 in the second region 132 is less than 3×10³ pcs/mm², an effect of volatilization of the organic solvents may be reduced, resulting in residues of the organic solvents in the second region 132, thereby reducing reliability of the soldering between the electrode line 12 and the solar cell 11. If the number of the recessed portions 133 in the second region 132 is greater than 3×10⁴ pcs/mm², an area of contact between the connecting member 13 in the second region 132 and the electrode line 12 may be reduced, and strength of the connection between the second region 132 and the electrode line 12 may be reduced.

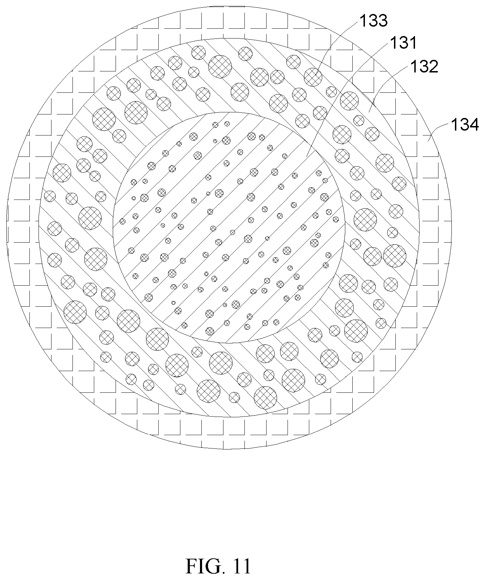

As shown in FIG. 11, in some possible embodiments, the connecting member 13 further includes a third region 134, and the third region 134 is arranged around the second region 132. During the heating of the connecting member 13, the organic solvents may precipitate along a direction from the first region 131 to the second region 132. During the precipitation, part of the organic solvents may volatilize in the first region 131 and the second region 132, such that recessed portions 133 are formed in the first region 131 and the second region 132, and some non-volatilizing organic solvents may continue to precipitate to edges of the second region 132, forming a third region 134 around the second region 132.

Along a width direction Y of the photovoltaic module, a width of the third region 134 is less than that of the second region 132. During the heating of the connecting member 13, most of the organic solvents may volatilize in the first region 131 or the second region 132, and a small part of the organic solvents may form the third region 134. Therefore, the width of the third region 134 is less than that of the second region 132.

The third region 134 is composed of non-volatilizing organic solvents. Therefore, the third region 134 includes no recessed portions 133 formed due to the volatilization of the organic solvents. arrangement density of the recessed portions 133 in the first region 131 may range from 100 pcs/mm² to 2000 pcs/mm². For example, the arrangement density of the recessed portions 133 in the first region 131 may be 100 pcs/mm², 500 pcs/mm², 1000 pcs/mm², 1500 pcs/mm², 2000 pcs/mm², or the like. Compared with the first region 131 and the second region 132, arrangement density of the recessed portions 133 in the third region 134 may range from 0 to 100 pcs/mm². For example, the arrangement density of the recessed portions 133 in the third region 134 may be 0, 20 pcs/mm², 40 pcs/mm², 60 pcs/mm², 80 pcs/mm², 100 pcs/mm², or the like. Therefore, the third region 134 has higher flatness than the first region 131 and the second region 132. In the first region 131 and the second region 132 of the connecting member 13, the organic solvents precipitate, main components are tin-lead, tin-bismuth-silver, or the like, and transparency thereof is less than that of the organic solvents. Transparency of the third region 134 is approximately 70% to 80%, which may be, for example, 70%, 75%, 80%, or the like. The first region 131 and the second region 132 are opaque or less transparent than the third region 134.

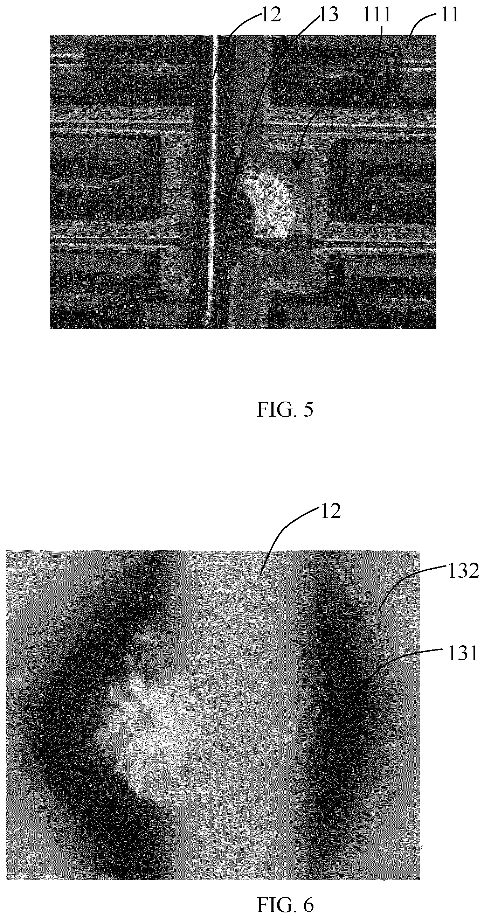

As shown in FIG. 5 to FIG. 7, in some possible embodiments, the first region 131 has recessed portions 133 on the surface. In the projections along the thickness direction of the photovoltaic module, the projection of the recessed portion 133 on the solar cell 11 is located outside a range of the projection of the electrode line 12 on the solar cell 11.

The electrode line 12 is connected to the solar cell 11 through the connecting member 13. Therefore, the electrode line 12 has an overlapping portion with the first region 131. If the recessed portion 133 is arranged in the overlapping portion between the electrode line 12 and the first region 131, the area of contact between the electrode line 12 and the connecting member 13 may be reduced, resulting in a decrease in the strength of the connection between the electrode line 12 and the connecting member 13. If the recessed portion 133 in the first region 131 is outside an overlapping region between the electrode line 12 and the first region 131, an influence of the recessed portion 133 on the strength of the connection between the electrode line 12 and the connecting member 13 can be reduced.

In some possible embodiments, along the width direction Y of the photovoltaic module, the width of the second region 132 is less than or equal to 30 µm.

In the connecting member 13, one part of the organic solvents volatilize during the soldering, and the other part of the organic solvents precipitate to form the second region 132. If the width of the second region 132 is greater than 30 µm, content of the organic solvents in the connecting member 13 is more, resulting in precipitation of more organic solvents, and there may be residues of the organic solvents in the first region 131, affecting strength of the soldering between the electrode line 12 and the solar cell 11.

In some possible embodiments, the recessed portion 133 is formed by the breakage of the bubbles formed by the gasification of the organic solvents in the connecting member 13. Therefore, in the projections along the thickness direction Z of the photovoltaic module, the projection of the recessed portion 133 in the solar cell 11 is in a shape of a circle or an ellipse.

Since the projection of the recessed portion 133 along the thickness direction Z of the photovoltaic module is in the shape of a circle or an ellipse, the recessed portion 133 may be hemispherical or cylindrical, which facilitates the organic solvents to volatilize from the connecting member 13, reducing the residues of the organic solvents in the connecting member 13, and helping to improve the reliability of the soldering between the electrode line 12 and the solar cell 11.

In some possible embodiments, along the width direction of the photovoltaic module, the size of the recessed portion 133 ranges from 3 µm to 15 µm.

The size of the recessed portion 133 may be 3 µm, 6 µm, 9 µm, 12 µm, 15 µm, or the like, which is 9 µm in some embodiments. If a width of the recessed portion 133 is less than 3 µm, an effect of volatilization of the organic solvents in the connecting member 13 may be reduced. If the width of the recessed portion 133 increases, it is easier for the organic solvents to volatilize. Along the width direction Y of the photovoltaic module, a width of the connecting member 13 ranges from 0.2 mm to 1 mm. If the width of the recessed portion 133 is greater than 15 µm, the recessed portion 133 accounts for a larger portion in the connecting member 13, which may affect the strength of the connection between the electrode line 12 and the connecting member 13.

As shown in FIG. 5 to FIG. 7, in some possible embodiments, the organic solvents in the connecting member 13 have one part volatilizing in the first region 131 to form the recessed portions 133 and the other part precipitating from the first region 131 to form the second region 132. The arrangement density of the recessed portions 133 in the first region 131 may range from 100 pcs/mm² to 2000 pcs/mm². For example, the arrangement density of the recessed portions 133 in the first region 131 may be 100 pcs/mm², 500 pcs/mm², 1000 pcs/mm², 1500 pcs/mm², 2000 pcs/mm², or the like. The arrangement density of the recessed portions 133 in the second region 132 may be 0, 20 pcs/mm², 40 pcs/mm², 60 pcs/mm², 80 pcs/mm², 100 pcs/mm², or the like. The arrangement density of the recessed portions 133 in the second region 132 is lower. Therefore, the second region 134 has lower pore density and higher flatness.

In some possible embodiments, the first region 131 may be solder paste. The solder paste may improve capillarity and wettability, and reduce a possibility of cold soldering between the electrode line 12 and the solar cell 11. At the same time, the solder paste may also isolate the air to prevent oxidation of solder joints between the electrode line 12 and the solar cell 11, helping to improve the reliability of the soldering between the electrode line 12 and the solar cell 11.

The solar cells 11 arranged in parallel are connected into the solar cell string 1 through the electrode line 12, an upper surface and a lower surface of the solar cell string 1 are both provided with adhesive films, the upper surface of the solar cell string 1 is further provided with photovoltaic glass connected to the solar cell string 1 through the adhesive film, and the lower surface of the solar cell string 1 is further provided with photovoltaic glass or a back sheet which is also connected to the solar cell string 1 through the adhesive film to form the photovoltaic module.

Some embodiments of the present disclosure further provide a manufacturing method for manufacturing a photovoltaic module for a photovoltaic module. The photovoltaic module includes solar cell strings 1, a back sheet, an adhesive film, and photovoltaic glass. The solar cell string 1 includes solar cells 11, a electrode line 12, and connecting members 13. The electrode line 12 is connected to the solar cells 11 through the connecting members 13.

The method for manufacturing a photovoltaic module includes:
S1: placing the connecting members 13 in soldering regions 111 of the solar cells 11;
S2: placing the solar cells 11 with the connecting members 13 on an operating platform 2;
S3: placing the electrode line 12 on one sides of the solar cells 11 provided with the connecting members 13;
S4: heating the electrode line 12 and the connecting members 13 to obtain the solar cell string 1; and
S5: laminating the back sheet, the adhesive film, the solar cell strings 1, and the photovoltaic glass to obtain the photovoltaic module.

The connecting member 13 is arranged between the electrode line 12 and the solar cell 11, which can improve the strength of the connection between the electrode line 12 and the solar cell 11 and reduce a possibility of cold soldering. Both the connecting member 13 and the electrode line 12 are placed on a surface of the solar cell 11, which omits the step of curing the connecting member 13 on the solar cell 11, helping to improve manufacturing efficiency of the solar cell string 1.

When the connecting members 13 are placed in the soldering regions 111 of the solar cells 11, the method for manufacturing a photovoltaic module includes: S11: printing the connecting members 13 in the soldering regions 111 of the solar cells 11.

The connecting member 13 is arranged in the soldering region 111 by printing, which facilitates the control over a position and a shape of the connecting member 13, enabling the connecting member 13 to be located at a position where the electrode line 12 and the solar cell 11 are soldered. When the electrode line 12 is soldered to the solar cell 11, the connecting member 13 can reduce a possibility of colder soldering.

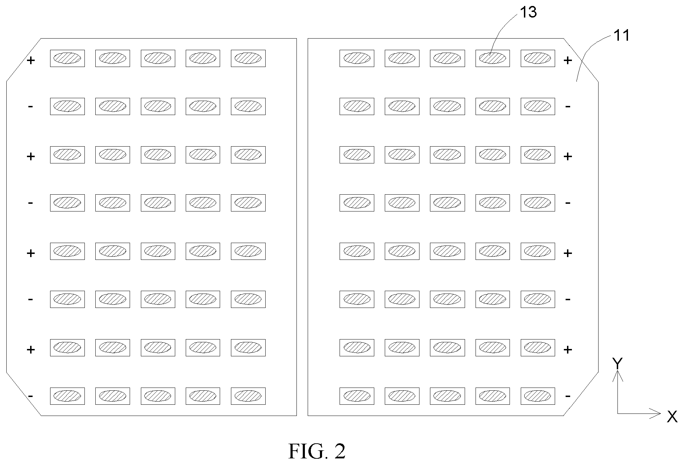

As shown in FIG. 2 and FIG. 3, in some possible embodiments, the solar cell 11 includes a positive busbar and a negative busbar, the positive busbars and the negative busbars are alternately arranged on the solar cells 11 along a width direction Y of the photovoltaic module, and positions of the positive busbars and the negative busbars in the solar cells 11 are consistent. Therefore, when the solar cells 11 are placed on the operating platform 2, along a length direction X of the photovoltaic module, in adjacent solar cells 11, the positive busbars are located on a same straight line and the negative busbars are located on a same straight line.

When the solar cells 11 with the connecting members 13 are placed on the operating platform 2, the method for manufacturing a photovoltaic module includes: S21: rotating one of two adjacent solar cells 11 by 180° such that, in the adjacent solar cells 11, the positive busbar of one and the negative busbar of the other are located on a same straight line along the length direction X of the photovoltaic module.

The electrode line 12 is configured to connect the positive busbars and the negative busbars in the adjacent solar cells 11, and in the adjacent solar cells 11, the positive busbar of one and the negative busbar of the other are located on a same straight line, such that the electrode line 12 can be arranged on one side of the solar cell 11 provided with the positive busbar and the negative busbar.

After the electrode lines 12 are placed on one sides of the solar cells 11 provided with the connecting members 13, the method for manufacturing a photovoltaic module includes: S31: fixing the electrode lines 12 to the sides of the solar cells 11 provided with the connecting members 13.

A force is applied to the electrode line 12 on a side of the electrode line 12 away from the solar cell 11 to fix the electrode line 12 to the solar cell 11, which reduces a possibility of displacement of the electrode line 12 during subsequent soldering between the electrode line 12 and the solar cell 11, helping to increase a yield of the solar cell string 1.

In some possible embodiments, the operating platform 2 for placing the solar cell 11 can heat the solar cell 11 and then solder the solar cell 11 and the electrode line 12.

When the solar cells 11 are heated to obtain the solar cell string 1, the method for manufacturing a photovoltaic module includes: a heating temperature ranging from 130°C to 220°C, and heating time ranging from 1.5 s to 6 s.

During the heating, the solar cell 11 transfers heat emitted by a heating platform to the connecting member 13 and the electrode line 12, causing the connecting member 13 to melt to connect the electrode line 12 and the solar cell 11. During the heating, the heating temperature may be 130°C, 150°C, 170°C, 190°C, 210°C, 220°C, or the like, and the heating time may be 1.5 s, 2.5 s, 3.5 s, 4.5 s, 5.5 s, 6 s, or the like. The organic solvents in the connecting member 13 have one part volatilizing in the first region 131 to form recessed portions 133 and the other part precipitating from the first region 131 to form the second region 132.

In some possible embodiments, a heating apparatus is arranged on one side of the solar cell 11 away from the operating platform 2. The heating apparatus may be an infrared lamp box. The electrode line 12 and the connecting member 13 are heated by the heating apparatus, thereby soldering the solar cell 11 and the electrode line 12.

When the solar cells 11 are heated to obtain the solar cell string 1, the method for manufacturing a photovoltaic module includes: a heating temperature ranging from 230°C to 240°C, and heating time being less than or equal to 5 s.

When the solar cell 11 is heated, the heating temperature may be 230°C, 235°C, 240°C, or the like. In the manner of heating the connecting member 13 and the electrode line 12 through the infrared heating apparatus, the solar cell 11 is not required to transfer heat, and at the same time, the infrared heating apparatus can provide a higher temperature. Therefore, the soldering between the electrode line 12 and the solar cell 11 can be completed when the heating time is less than or equal to 5 s.

In some possible embodiments, when the connecting members 13 are placed in the soldering regions 111 of the solar cells 11, the method for manufacturing a photovoltaic module includes: fixing the connecting members 13 to the solar cells 11 by heating.

The connecting member 13 is first fixed to the solar cell 11 by heating, which limits a relative position between the connecting member 13 and the solar cell 11. In the step of soldering the electrode line 12 and the solar cell 11 through the connecting member 13, a possibility of displacement of the connecting member 13 is reduced, and a possibility of colder soldering between the electrode line 12 and the solar cell 11 is reduced.

The connecting member 13 may be solder paste. When the connecting members 13 are fixed to the solar cells 11 by heating, the method for manufacturing a photovoltaic module includes: S21: heating the solder paste to 120°C to 180°C for 10 s to 60 s.

The solar cell 11 printed with the solder paste is placed in a curing furnace for heating. A heating temperature may be 120°C, 130°C, 140°C, 150°C, 160°C, 170°C, 180°C, or the like, and heating time may be 10 s, 20 s, 30 s, 40 s, 50 s, 60 s, or the like. The solder paste is cured and fixed to the solar cell 11. The solder paste includes organic solvents such as flux. During the curing of the solder paste, the organic solvents such as flux in the solder paste may volatilize or precipitate from a center of the solder paste to edges, which reduces content of the organic solvents in the solder paste and can improve strength of the soldering between the electrode line 12 and the solar cell 11.

Some embodiments of the present disclosure further provide a machining device, for manufacturing a photovoltaic module. The machining device includes an operating platform 2, pressing tools 3, and a heating apparatus. The pressing tool 3 is mounted on the operating platform 2 and configured to limit positions of solar cells 11 and electrode lines 12 in the photovoltaic module. The heating apparatus is configured to heat connecting members 13 and the electrode lines 12.

The solar cell 11 is placed on the operating platform 2. One side of the solar cell 11 provided with no positive busbar and no negative busbar faces the operating platform 2. The pressing tool 3 includes a bracket 31 and abutting members 32. The bracket 31 is configured to fix positions of the abutting members 32, such that the abutting members 32 are located above the electrode line 12. The abutting members 32 are connected to the bracket 31 through an elastic member 33. When the pressing tool 3 fixes the position of the electrode line 12, one ends of the abutting members 32 away from the bracket 31 abut against the electrode line 12 and may compress the elastic member 33 at the same time. An elastic force of the elastic member 33 may be transferred to the electrode line 12 through the abutting members 32, such that the electrode line 12 is fixed to the solar cells 11, facilitating heating of the solar cells 11, the connecting members 13, and the electrode line 12 to form the solar cell string 1.

In some possible embodiments, the heating apparatus is located in the operating platform 2, the solar cell 11 can be placed on a surface of the heating apparatus, and the solar cell 11 is heated through the heating apparatus to melt the connecting member 13 and then connect the electrode line 12 and the solar cell 11.

Through the arrangement of the heating apparatus in the operating platform 2, one side of the solar cell 11 provided with the busbars can be heated, heat is transferred, through the solar cell 11, to the side of the solar cell 11 provided with the busbars to heat the connecting member 13 and the electrode line 12, and then the electrode line 12 and the solar cell 11 can be connected.

In some possible embodiments, the heating apparatus is a curing furnace, a heating member is arranged in the curing furnace, the solar cell 11 can enter the curing furnace along with the operating platform 2, the heating member is located on one side of the solar cell 11 where the connecting member 13 and the electrode line 12 are placed, and the solar cell 11, the connecting member 13, and the electrode line 12 are heated through the heating member, to connect the electrode line 12 and the solar cell 11.

The heating member may be an infrared heating apparatus, and the connecting member 13 and the electrode line 12 can be directly heated through the infrared heating apparatus. At the same time, a heating temperature of the infrared heating apparatus is higher, such that the connecting member 13 can melt more easily and then connect the electrode line 12 and the solar cell 11.

As shown in FIG. 4, in some possible embodiments, the pressing tool 3 includes a bracket 31 and abutting members 32. The bracket 31 is configured to fix positions of the abutting members 32. The abutting members 32 are configured to provide forces for the electrode line 12. The abutting members 32 are connected to the bracket 31 through an elastic member 33. When the pressing tool 3 fixes the position of the electrode line 12, one ends of the abutting members 32 away from the bracket 31 abut against the electrode lines 12 and may compress the elastic member 33 at the same time. An elastic force of the elastic member 33 may be transferred to the electrode line 12 through the abutting members 32, such that the electrode line 12 is fixed to the solar cells 11.

Through the operating platform 2 and the pressing tool 3, relative positions of the solar cell 11 and the electrode line 12 can be limited, which reduces a possibility of displacement of the electrode line 12 during the soldering and helps to increase a yield of the photovoltaic module.

In some possible embodiments, the machining device further includes a heating apparatus and a soldering apparatus. The heating apparatus and the soldering apparatus are located upstream of the operating platform and downstream of the operating platform respectively. After the connecting members are arranged on the surface of the solar cells, the heating apparatus is entered first, the connecting members are cured, and the connecting members are fixed to the solar cells. Then, the solar cells are placed on the operating platform, and relative positions of the electrode lines and the solar cells are limited through the pressing tools, which are finally placed in the soldering apparatus to solder the electrode lines and the solar cells.

Some embodiments of the present disclosure provide a photovoltaic module, a manufacturing method for manufacturing a photovoltaic module for a photovoltaic module, and a machining device. The photovoltaic module includes solar cell strings 1 and electrode lines 12. The solar cell string 1 includes solar cells 11 arranged in parallel, and the electrode line 12 is located on one sides of the solar cells 11 and configured to connect adjacent solar cells 11 to form the solar cell string 1. soldering regions 111 are arranged apart on the solar cell 11 along a length direction X of the photovoltaic module, connecting members 13 are arranged in the soldering regions 111, the electrode line 12 is located on one sides of the solar cells 11 provided with the connecting members 13, and the connecting members 13 can reduce a possibility of cold soldering between the electrode line 12 and the solar cells 11, helping to increase a yield of the solar cell string 1. The connecting member 13 includes a first region 131 and a second region 132. The second region 132 is arranged around the first region 131, and transparency of the second region 132 is greater than that of the first region 131.

The above are merely some embodiments of the present disclosure, and are not intended to limit the present disclosure. For those skilled in the art, the present disclosure may be subject to various modifications and changes. Any modification, equivalent replacement, improvement and the like within the protection scope of the claims.

## Claims

1. A photovoltaic module, comprising:
a solar cell string (1) comprising solar cells (11) which are arranged in parallel along a length direction of the photovoltaic module; and
electrode lines (12), each of the electrode lines (12) being located on a back side of a corresponding solar cell (11) and configured to connect adjacent solar cells (11),
wherein soldering regions (111) are arranged on a side of each of the solar cells (11) facing the electrode lines (12), and arranged apart along the length direction of the photovoltaic module, the electrode lines (12) are connected to the soldering regions (111), connecting members (13) are arranged between the soldering regions (111) and the electrode lines (12), the electrode lines (12) are connected to the soldering regions (111) through the connecting members (13), and each of the connecting members (13) comprises a first region (131) and a second region (132), wherein the first region (131) is made of tin-lead or tin-bismuth-silver and the second region (132) is made of precipitated organic solvents ;
wherein the second region (132) is arranged around the first region (131), and the transparency of the second region (132) is greater than the transparency of the first region (131);
**characterized in that**
the second region (132) has a width less than or equal to 30 µm;
**in that** at least one recessed portion (133) is arranged on a surface of the first region (131), and the at least one recessed portion (133) is formed by volatilizing the organic solvents in the connecting member (13) during soldering the electrode lines (12) to the soldering regions (111);
and **in that** the at least one recessed portion comprises a plurality of recessed portions (133) arranged on the surface of the first region (131), and the plurality of recessed portions (133) are arranged apart from each other on the surface of the first region (131).

2. The photovoltaic module according to claim 1,
wherein the second region (132) has a surface pore density less than a surface pore density of the first region (131).

3. The photovoltaic module according to claim 1, wherein, in the first region (131), an arrangement density of the at least one recessed portion (133) ranges from 100 pcs/mm² to 2000 pcs/mm²; or
wherein, along a thickness direction of the photovoltaic module, a projection of the at least one recessed portion (133) is located outside projections of the electrode lines (12).

4. The photovoltaic module according to claim 1, wherein, along a thickness direction of the photovoltaic module, a projection of each of the at least one recessed portion (133) in a corresponding solar cell (11) is in a shape of a circle or an ellipse.

5. The photovoltaic module according to claim 1, wherein, along a thickness direction of the photovoltaic module, a projection of each of the at least one recessed portion (133) in the solar cell (11) has a size ranging from 3 µm to 15 µm along a width direction of the photovoltaic module.

6. The photovoltaic module according to claim 1, wherein the first region (131) is provided with a solder paste.

7. A method for manufacturing a photovoltaic module according to claim 1, wherein the photovoltaic module comprises a solar cell string (1), a back sheet, an adhesive film, and photovoltaic glass, and the solar cell string (1) comprises solar cells (11), electrode lines (12), and connecting members (13), wherein the method comprises:
placing the connecting members (13) in soldering regions (111) of the solar cells (11);
placing the solar cells (11) with the connecting members (13) on an operating platform (2);
placing each of the electrode lines (12) on a side of a corresponding solar cell (11) provided with the connecting members (13) thereon;
heating the electrode lines (12) and the connecting members (13) to obtain the solar cell string (1); and
laminating the back sheet, the adhesive film, the solar cell strings (1), and the photovoltaic glass to obtain the photovoltaic module.

8. The method according to claim 7, wherein each of the solar cells (11) comprises a positive busbar and a negative busbar, the positive busbars and the negative busbars are alternately arranged along a width direction of the photovoltaic module, and when the solar cells (11) with the connecting members (13) are placed on the operating platform (2), the method comprises:
rotating one of two adjacent solar cells (11) by 180° such that, in the adjacent solar cells (11), the positive busbar of one of the two adjacent solar cells and the negative busbar of the other of the two adjacent solar cells are located on a same straight line along a length direction of the photovoltaic module; or
wherein the heating the electrode lines (12) and the connecting members (13) to obtain the solar cell string (1) is performed at a heating temperature ranging from 130°C to 220°C for 1.5 s to 6 s; or
wherein, the heating the electrode lines (12) and the connecting members (13) to obtain the solar cell string (1) is performed at a heating temperature ranging from 230°C to 240°C for no more than 5 s.

9. A machining device, for manufacturing a photovoltaic module according to claim 1, wherein the photovoltaic module comprises solar cells (11), electrode lines (12), and connecting members (13), wherein the machining device comprises:
an operating platform (2), wherein the solar cells (11) are located on a surface of the operating platform (2);
a pressing tool (3), located on a side of the operating platform (2) where the solar cells (11) are placed; and
a heating apparatus, configured to heat the solar cells (11) and the connecting members (13).

10. The machining device according to claim 9,
wherein the heating apparatus is located in the operating platform (2), and the solar cells (11) are placed in the heating apparatus; or
wherein the heating apparatus is a curing furnace, and the operating platform (2) is capable of entering the curing furnace;
the curing furnace comprises a heating member, and the heating member is located on a side of a corresponding solar cell (11) away from the operating platform (2).

11. The machining device according to claim 9, wherein the pressing tool (3) comprises a bracket (31) and abutting members (32), and the bracket (31) is arranged parallel to each of the electrode lines (12) along a height direction of the machining device, and each of the abutting members (32) has one end connected to the bracket (31) and another end capable of abutting against one of the electrode lines (12).

12. The machining device according to claim 11, wherein the pressing tool (3) further comprises elastic members (33), and the bracket (31) and the abutting members (32) are connected to each other through the elastic members (33).

## Patentansprüche

1. Photovoltaikmodul, umfassend:
einen Solarzellenstrang (1), der Solarzellen (11) umfasst, die parallel entlang einer Längsrichtung des Photovoltaikmoduls angeordnet sind; und
Elektrodenleitungen (12), wobei sich jede der Elektrodenleitungen (12) auf einer Rückseite einer entsprechenden Solarzelle (11) befindet und so ausgebildet ist, dass sie benachbarte Solarzellen (11) verbindet,
wobei Lötbereiche (111) auf einer den Elektrodenleitungen (12) zugewandten Seite jeder der Solarzellen (11) angeordnet sind und entlang der Längsrichtung des Photovoltaikmoduls voneinander beabstandet angeordnet sind, die Elektrodenleitungen (12) mit den Lötbereichen (111) verbunden sind, Verbindungselemente (13) zwischen den Lötbereichen (111) und den Elektrodenleitungen (12) angeordnet sind, die Elektrodenleitungen (12) über die Verbindungselemente (13) mit den Lötbereichen (111) verbunden sind, und jedes der Verbindungselemente (13) einen ersten Bereich (131) und einen zweiten Bereich (132) umfasst, wobei der erste Bereich (131) aus Zinn-Blei oder Zinn-Bismut-Silber gefertigt ist und der zweite Bereich (132) aus ausgefällten organischen Lösungsmitteln gefertigt ist;
wobei der zweite Bereich (132) um den ersten Bereich (131) herum angeordnet ist und die Transparenz des zweiten Bereichs (132) größer ist als die Transparenz des ersten Bereichs (131);
**dadurch gekennzeichnet,**
**dass** der zweite Bereich (132) eine Breite von weniger als oder gleich 30 µm aufweist;
**dass** mindestens eine Vertiefung (133) auf einer Oberfläche des ersten Bereichs (131) angeordnet ist und die mindestens eine Vertiefung (133) durch Verflüchtigen der organischen Lösungsmittel in dem Verbindungselement (13) während des Lötens der Elektrodenleitungen (12) an die Lötbereiche (111) gebildet wird;
und **dass** die mindestens eine Vertiefung eine Vielzahl von Vertiefungen (133) umfasst, die auf der Oberfläche des ersten Bereichs (131) angeordnet sind, und die Vielzahl von Vertiefungen (133) voneinander beabstandet auf der Oberfläche des ersten Bereichs (131) angeordnet sind.

2. Photovoltaikmodul nach Anspruch 1,
wobei der zweite Bereich (132) eine Oberflächenporendichte aufweist, die geringer ist als eine Oberflächenporendichte des ersten Bereichs (131).

3. Photovoltaikmodul nach Anspruch 1, wobei in dem ersten Bereich (131) eine Anordnungsdichte der mindestens einen Vertiefung (133) im Bereich von 100 Stück/mm² bis 2000 Stück/mm²liegt; oder
wobei entlang einer Dickenrichtung des Photovoltaikmoduls eine Projektion der mindestens einen Vertiefung (133) außerhalb von Projektionen der Elektrodenleitungen (12) liegt.

4. Photovoltaikmodul nach Anspruch 1, wobei entlang einer Dickenrichtung des Photovoltaikmoduls eine Projektion jeder der mindestens eine Vertiefung (133) in einer entsprechenden Solarzelle (11) die Form eines Kreises oder einer Ellipse aufweist.

5. Photovoltaikmodul nach Anspruch 1, wobei entlang einer Dickenrichtung des Photovoltaikmoduls eine Projektion jeder der mindestens einen Vertiefung (133) in der Solarzelle (11) eine Größe im Bereich von 3 µm bis 15 µm entlang einer Breitenrichtung des Photovoltaikmoduls aufweist.

6. Photovoltaikmodul nach Anspruch 1, wobei der erste Bereich (131) mit einer Lötpaste versehen ist.

7. Verfahren zur Herstellung eines Photovoltaikmoduls nach Anspruch 1, wobei das Photovoltaikmodul einen Solarzellenstrang (1), eine Rückseitenfolie, eine Klebefolie und Photovoltaikglas umfasst und der Solarzellenstrang (1) Solarzellen (11), Elektrodenleitungen (12) und Verbindungselemente (13) umfasst, wobei das Verfahren umfasst:
Anordnen der Verbindungselemente (13) in Lötbereichen (111) der Solarzellen (11);
Anordnen der Solarzellen (11) mit den Verbindungselementen (13) auf einer Arbeitsplattform (2);
Anordnen jeder der Elektrodenleitungen (12) auf einer Seite einer entsprechenden Solarzelle (11), die mit den Verbindungselementen (13) versehen ist;
Erhitzen der Elektrodenleitungen (12) und der Verbindungselemente (13), um den Solarzellenstrang (1) zu erhalten; und
Laminieren der Rückseitenfolie, der Klebefolie, der Solarzellenstränge (1) und des Photovoltaikglases, um das Photovoltaikmodul zu erhalten.

8. Verfahren nach Anspruch 7,
wobei jede der Solarzellen (11) eine positive Stromschiene und eine negative Stromschiene umfasst, die positiven Stromschienen und die negativen Stromschienen abwechselnd entlang einer Breitenrichtung des Photovoltaikmoduls angeordnet sind, und wenn die Solarzellen (11) mit den Verbindungselementen (13) auf der Arbeitsplattform (2) platziert sind, das Verfahren umfasst:
Drehen einer von zwei benachbarten Solarzellen (11) um 180°, so dass in den benachbarten Solarzellen (11) die positive Stromschiene einer der zwei benachbarten Solarzellen und die negative Stromschiene der anderen der zwei benachbarten Solarzellen auf einer gemeinsamen geraden Linie entlang einer Längsrichtung des Photovoltaikmoduls liegen; oder
wobei das Erhitzen der Elektrodenleitungen (12) und der Verbindungselemente (13) zum Erhalten des Solarzellenstrangs (1) bei einer Erhitzungstemperatur im Bereich von 130 °C bis 220 °C für 1,5 s bis 6 s durchgeführt wird; oder
wobei das Erwärmen der Elektrodenleitungen (12) und der Verbindungselemente (13) zum Erhalten des Solarzellenstrangs (1) bei einer Erhitzungstemperatur im Bereich von 230 °C bis 240 °C für nicht länger als 5 s durchgeführt wird.

9. Bearbeitungsvorrichtung zur Herstellung eines Photovoltaikmoduls gemäß Anspruch 1,
wobei das Photovoltaikmodul Solarzellen (11), Elektrodenleitungen (12) und Verbindungselemente (13) umfasst, wobei die Bearbeitungsvorrichtung umfasst:
eine Arbeitsplattform (2), wobei die Solarzellen (11) auf einer Oberfläche der Arbeitsplattform (2) angeordnet sind;
ein Presswerkzeug (3), das an einer Seite der Arbeitsplattform (2) angeordnet ist, wo die Solarzellen (11) platziert sind; und
ein Heizgerät, das dazu ausgelegt ist, die Solarzellen (11) und die Verbindungselemente (13) zu erhitzen.

10. Bearbeitungsvorrichtung nach Anspruch 9,
wobei sich das Heizgerät in der Arbeitsplattform (2) befindet und die Solarzellen (11) in dem Heizgerät angeordnet sind; oder
wobei das Heizgerät ein Aushärtungsofen ist und die Arbeitsplattform (2) in den Aushärtungsofen eingeführt werden kann;
der Aushärtungsofen ein Heizelement umfasst und das Heizelement auf einer von der Arbeitsbühne (2) abgewandten Seite einer entsprechenden Solarzelle (11) angeordnet ist.

11. Bearbeitungsvorrichtung nach Anspruch 9,
wobei das Presswerkzeug (3) eine Halterung (31) und Anlageteile (32) umfasst, und die Halterung (31) parallel zu jeder der Elektrodenleitungen (12) entlang einer Höhenrichtung der Bearbeitungsvorrichtung angeordnet ist, und jedes der Anlageteile (32) ein Ende aufweist, das mit der Halterung (31) verbunden ist, und ein anderes Ende, das an einer der Elektrodenleitungen (12) anliegen kann.

12. Bearbeitungsvorrichtung nach Anspruch 11,
wobei das Presswerkzeug (3) ferner elastische Elemente (33) umfasst und die Halterung (31) und die Anlageteile (32) über die elastischen Elemente (33) miteinander verbunden sind.

## Revendications

1. Module photovoltaïque, comprenant :
une chaîne de cellules solaires (1) comprenant des cellules solaires (11) qui sont agencées en parallèle le long d'une direction longitudinale du module photovoltaïque ; et
des lignes d'électrode (12), chacune des lignes d'électrode (12) étant située sur un côté arrière d'une cellule solaire (11) correspondante et configurée pour connecter des cellules solaires (11) adjacentes,
dans lequel des régions de soudage (111) sont agencées sur un côté de chacune des cellules solaires (11) faisant face aux lignes d'électrode (12), et agencées à distance le long de la direction longitudinale du module photovoltaïque, les lignes d'électrode (12) étant connectées aux régions de soudage (111), des éléments de connexion (13) étant agencés entre les régions de soudage (111) et les lignes d'électrode (12), les lignes d'électrode (12) étant connectées aux régions de soudage (111) via les éléments de connexion (13), et chacun des éléments de connexion (13) comprenant une première région (131) et une deuxième région (132), la première région (131) étant faite à partir d'étain-plomb ou d'étain-bismuth-argent et la deuxième région (132) étant faite à partir de solvants organiques précipités ;
dans lequel la deuxième région (132) est agencée autour de la première région (131), et la transparence de la deuxième région (132) est supérieure à la transparence de la première région (131) ;
**caractérisé en ce que**
la deuxième région (132) a une largeur inférieure ou égale à 30 µm ;
**en ce que**
au moins une portion évidée (133) est agencée sur une surface de la première région (131), et ladite au moins une portion évidée (133) est formée par volatilisation des solvants organiques dans l'élément de connexion (13) pendant le soudage des lignes d'électrode (12) aux régions de soudage (111) ;
et **en ce que**
ladite au moins une portion évidée comprend une pluralité de portions évidées (133) agencées sur la surface de la première région (131), et la pluralité de portions évidées (133) sont agencées à distance les unes des autres sur la surface de la première région (131).

2. Module photovoltaïque selon la revendication 1,
dans lequel la deuxième région (132) a une densité surfacique de pores inférieure à une densité surfacique de pores de la première région (131).

3. Module photovoltaïque selon la revendication 1, dans lequel, dans la première région (131), une densité d'agencement de ladite au moins une portion évidée (133) va de 100 pcs/mm² à 2000 pcs/mm² ; ou
dans lequel, le long d'une portion d'épaisseur du module photovoltaïque, une projection de ladite au moins une portion évidée (133) est située à l'extérieur de projections des lignes d'électrode (12).

4. Module photovoltaïque selon la revendication 1, dans lequel, le long d'une direction de l'épaisseur du module photovoltaïque, une projection de chacune desdites au moins une portion évidée (133) dans une cellule solaire (11) correspondante est en forme de cercle ou d'ellipse.

5. Module photovoltaïque selon la revendication 1, dans lequel, le long d'une direction de l'épaisseur du module photovoltaïque, une projection de chacune desdites au moins une portion évidée (133) dans la cellule solaire (11) a une taille allant de 3 µm à 15 µm le long d'une direction de la largeur du module photovoltaïque.

6. Module photovoltaïque selon la revendication 1, dans lequel la première région (131) est pourvue d'une pâte à souder.

7. Procédé de fabrication d'un module photovoltaïque selon la revendication 1, dans lequel
le module photovoltaïque comprend une chaîne de cellules solaires (1), une feuille arrière, un film adhésif et un verre photovoltaïque, et la chaîne de cellules solaires (1) comprend des cellules solaires (11), des lignes d'électrode (12), et des éléments de connexion (13), dans lequel le procédé comprend les étapes consistant à :
placer les éléments de connexion (13) dans des régions de soudage (111) des cellules solaires (11) ;
placer les cellules solaires (11) avec les éléments de connexion (13) sur une plate-forme opérationnelle (2) ;
placer chacune des lignes d'électrode (12) sur un côté d'une cellule solaire (11) correspondante pourvue des éléments de connexion (13) sur celle-ci,
chauffer les lignes d'électrode (12) et les éléments de connexion (13) pour obtenir la chaîne de cellules solaires (1) ; et
stratifier la feuille arrière, le film adhésif, les chaînes de cellules solaires (1) et le verre photovoltaïque pour obtenir le module photovoltaïque.

8. Procédé selon la revendication 7,
dans lequel chacune des cellules solaires (11) comprend une barre omnibus positive et une barre omnibus négative, les barres omnibus positives et les barres omnibus négatives étant agencées en alternance long d'une direction de la largeur du module photovoltaïque, et quand les cellules solaires (11) avec les éléments de connexion (13) sont placées sur la plate-forme opérationnelle (2), le procédé comprend l'étape consistant à :
mettre en rotation l'une de deux cellules solaires (11) adjacentes à raison de 180° de telle sorte que, dans les cellules solaires (11) adjacentes, la barre omnibus positive de l'une des deux cellules solaires adjacentes et la barre omnibus négative de l'autre des deux cellules solaires adjacentes sont situées sur une même ligne droite le long d'une direction de la longueur du module photovoltaïque ; ou
dans lequel l'étape consistant à chauffer les lignes d'électrode (12) et les éléments de connexion (13) pour obtenir la chaîne de cellules solaires (1) est effectuée à une température de chauffe allant de 130 °C à 220 °C pendant 1,5 s à 6 s ; ou
dans lequel l'étape consistant à chauffer les lignes d'électrode (12) et les éléments de connexion (13) pour obtenir la chaîne de cellules solaires (1) est effectuée à une température de chauffe allant de 230 °C à 240 °C pendant pas plus de 5 s.

9. Dispositif d'usinage pour fabriquer un module photovoltaïque selon la revendication 1, dans lequel le module photovoltaïque comprend des cellules solaires (11), des lignes d'électrode (12), et des éléments de connexion (13), dans lequel le dispositif d'usinage comprend :
une plate-forme opérationnelle (2), les cellules solaires (11) étant situées sur une surface de la plate-forme opérationnelle (2) ;
un outil de pressage (3), situé sur un côté de la plate-forme opérationnelle (2) où sont placées les cellules solaires (11) ; et
un appareil de chauffe, configuré pour chauffer les cellules solaires (11) et les éléments de connexion (13).

10. Dispositif d'usinage selon la revendication 9,
dans lequel l'appareil de chauffe est situé dans la plate-forme opérationnelle (2), et les cellules solaires (11) sont placées dans l'appareil de chauffe ; ou
dans lequel l'appareil de chauffe est un four de durcissement, et la plate-forme opérationnelle (2) est capable d'entrer dans le four de durcissement ;
le four de durcissement comprend un élément de chauffe, et l'élément de chauffe est situé sur un côté d'une cellule solaire (11) correspondante en éloignement de la plate-forme opérationnelle (2).

11. Dispositif d'usinage selon la revendication 9,
dans lequel l'outil de pressage (3) comprend
un support (31) et des éléments de butée (32), et le support (31) est agencé en parallèle à chacune des lignes d'électrode (12) le long d'une direction de la hauteur du dispositif d'usinage, et chacun des éléments de butée (32) présente une extrémité connectée au support (31) et une autre extrémité capable de venir en butée contre l'une des lignes d'électrode (12).

12. Dispositif d'usinage selon la revendication 11,
dans lequel l'outil de pressage (3) comprend en outre des éléments élastiques (33), et le support (31) et les éléments de butée (32) sont connectés mutuellement par l'intermédiaire des éléments élastiques (33).
